# EUROPEAN PATENT APPLICATION

(11) **EP 2 731 131 A1**
(43) Date of publication of application: **14.05.2014**
(21) Application number: 12360076.9
(22) Date of filing: 08.11.2012
(51) Int. Cl.: H01L 23/467

(54) **Cooling assembly**

(71) Applicant: Alcatel Lucent, 75007 Paris (FR)
(72) Inventor: Akalanne, Lucius, Swindon, Wilts SN5 7DJ (GB)
(74) Representative: Leppard, Andrew John

(57) **Abstract**

A cooling assembly and method are disclosed. The cooling assembly comprises: a heat sink base thermally coupleable with a heat-generating component to be cooled; cooling fins thermally connected with the heat sink base to provide a thermal path from the heat-generating component to the cooling fins; and a displacement mechanism operable to reciprocate the cooling fins. By providing an arrangement where the cooling fins themselves reciprocate, the heat transfer to the ambient environment is significantly increased since the reciprocation of the cooling fins helps to break up the thermal and flow boundary layers of the ambient fluid surrounding the assembly and helps to promote more flow mixing and heat transfer away from the cooling fins' surface to the ambient environment. This provides an assembly which can be smaller in volume than either existing passive or forced air arrangement and, even with that smaller volume, can provide increased cooling performance.

## Description

### FIELD OF THE INVENTION

The present invention relates to a cooling assembly and method.

### BACKGROUND

Cooling assemblies are known. It is often the case that electronic apparatus contain components which need to be cooled in order to maintain normal operation. For example, data processing apparatus, such as a processor core, may need to be cooled in order to maintain correct operation. Different so-called "passive" approaches exist involving various heat sink structures which are placed in thermal contact with the device to be cooled and which transfer heat away from the device to the surrounding ambient environment in order to cool it. So-called "active" approaches also exist, such as a forced air arrangement, where a rotary fan is attached to a heat sink and blows air onto the heat sink to improve its heat transfer capability to the ambient environment to cool the device.

Although each of these arrangements can help to provide cooling to a device, they each have their own shortcomings.

Accordingly, it is desired to provide an improved technique for cooling a device.

### SUMMARY

According to a first aspect, there is provided a cooling assembly, comprising: a heat sink base thermally coupleable with a heat-generating component to be cooled; cooling fins thermally connected with the heat sink base to provide a thermal path from the heat-generating component to the cooling fins; and a displacement mechanism operable to reciprocate the cooling fins.

The first aspect recognises that a problem with existing passive arrangements is that their heat transfer ability to the ambient environment are largely dependent upon the surface area of the heat sink and upon achieving adequate convection flows of ambient fluid over that surface area. This requirement to maintain adequate convection places a minimum volume requirement on the heat sink. The first aspect also recognises that a problem with existing forced air arrangements is that whilst the addition of a rotary fan helps to improve heat transfer to ambient, the addition of the fan onto the heat sink also results in a larger volume device than may be desirable.

Accordingly, a cooling or heat sink assembly is provided. The assembly may comprise a heat sink base which may be thermally coupled or connected with a heat generating component that is to be cooled. One or more cooling fins may be connected with the heat sink base and provides a thermal path from the heat generating component to the cooling fins. A displacement mechanism may be provided which reciprocates or oscillates the cooling fins. By providing an arrangement where the cooling fins themselves reciprocate, the heat transfer to the ambient environment is significantly increased since the reciprocation of the cooling fins helps to break up the thermal and flow boundary layers of the ambient fluid surrounding the assembly and helps to promote more flow mixing and heat transfer away from the cooling fins' surface to the ambient environment. This provides an assembly which can be smaller in volume than either existing passive or forced air arrangement and, even with that smaller volume, can provide increased cooling performance.

In one embodiment, the cooling fins are thermally-conductive blades and the displacement mechanism imparts a displacement of the cooling fins. Accordingly, the cooling fins may be thermally conductive blades and the displacement mechanism displaces those thermally conductive blades. Again, this arrangement ensures that the cooling or heat transfer efficiency of the cooling fins is improved.

In one embodiment, the cooling fins are flexible and the displacement mechanism imparts a displacement of the cooling fins towards a proximal end of each cooling fin to generate a greater displacement of the cooling fins towards a distal end. Accordingly, a relatively small displacement of the cooling fin at one end may result in an increased displacement of the cooling fin at another end. It will be appreciated that the extent of displacement helps to increase the breakup of the boundary layers and increase mixing to improve the heat transfer efficiency.

In one embodiment, the displacement mechanism comprises a Piezo-electric assembly which receives each cooling fin, the Piezo-electric assembly being operable to reciprocate the cooling fins in response to a driving signal. Hence, a Piezo-electric assembly may be utilised to reciprocate the cooling fins in response to a varying electrical signal. It will be appreciated that using a Piezo-electric material is a particularly convenient, reliable and controllable way of imparting a displacement to the cooling fins.

In one embodiment, the displacement mechanism and cooling fin both comprise the Piezo-electric assembly. Accordingly, the whole cooling fin itself may comprise a Piezo-electric material, which provides for a combined cooling fin and displacement device.

In one embodiment, the Piezo-electric assembly comprises grapheme. Incorporating a Piezo-electric material into grapheme reduces weight, increases the thermal conductivity of the cooling fin and improves the heat transfer efficiency.

In one embodiment, the heat sink base comprises a plurality of base modules, each base module arranged to receive a cooling fin and associated displacement mechanism operable to reciprocate that cooling fin. Accordingly, the assembly may comprise a modular arrangement whereby the required number of modules may be assembled to provide the required configuration cooling assembly.

In one embodiment, the displacement mechanism is operable to switch between an activated state where the cooling fins are reciprocated and an inactive state where the cooling fins remain static. In this way, the assembly may be switched between an active cooling state where the cooling fins reciprocate and a passive cooling state where the cooling fins remain static. Accordingly, the device may also operate as a passive device.

In one embodiment, the displacement mechanism is operable to remain in the inactive state until a temperature of the heat-generating component exceeds a threshold value where the displacement mechanism switches to the activated state. Accordingly, the assembly may remain in the passive state until the cooling requirements are such that an increased cooling performance is required, at which point the assembly switches to an active state.

In one embodiment, the displacement mechanism is operable to vary at least one of a frequency and amplitude of reciprocation of the cooling fins in response to a temperature of the heat-generating component. Accordingly, the frequency or amplitude of reciprocation of the cooling fins may be varied in response to the temperature. Typically, the amplitude and/or frequency will increase with increasing temperature of the device in order to improve its cooling.

In one embodiment, the displacement mechanism is operable to reciprocate the cooling fins at their resonant frequency. By oscillating the cooling fins at one of their resonant frequencies, the displacement per unit of energy used to cause that displacement is maximised.

In one embodiment, the displacement mechanism is operable to reciprocate the cooling fins at an ultrasonic frequency. By oscillating the cooling fins at an ultrasonic frequency, the level of audible noise in the active state is minimised.

In one embodiment, the cooling fins are arranged in a plurality of rows. Arranging fins in sets of rows helps to increase the flow paths around the cooling fins and helps to match the shape of the assembly to the shape of the device to be cooled in order to improve the cooling performance of the assembly.

In one embodiment, the displacement mechanism is operable to reciprocate adjacent rows out of phase with respect to each other. By counter-reciprocating adjacent rows of cooling fins, increased turbulent fluid flow is achieved which helps with the breakup of flow boundary layers, improves flow mixing and improves the cooling performance of the assembly.

In one embodiment, the cooling fins upstand from the heat sink base.

In one embodiment, the cooling fins upstand at a non-normal inclination from the heat sink base. By causing the cooling fins to be inclined with respect to the heat sink base, the height occupied by the assembly can be further minimised.

In one embodiment, the cooling fins are metallic blades. Providing metallic blades helps to increase the thermal conductivity of the cooling fins.

In one embodiment, the cooling fins comprise surface undulations. Providing surface undulations can again help to break up the boundary layers, promote more mixing at the surface of the cooling fins and improves the cooling performance of the assembly.

In one embodiment, the assembly comprises a voltage generator operable to oppositely charge adjacent cooling fins to provide a flow of ionised particles. Causing cooling fins to have a voltage difference therebetween creates an ionic flow of particles which can also help to break up boundary layers, promote more flow mixing and improves the cooling performance of the assembly.

In one embodiment, the reciprocation of the cooling fins generates a fluid flow directable onto an adjacent heat-generating component to be cooled. Accordingly, the air flow generated by the cooling assembly may be used to cool another device. This may obviate the need to provide a further cooling assembly on that device.

According to a second aspect, there is provided a cooling method, comprising: providing a heat sink base thermally coupleable with a heat-generating component to be cooled; thermally connecting cooling fins with the heat sink base to provide a thermal path from the heat-generating component to the cooling fins; and reciprocating the cooling fins.

In one embodiment, the cooling fins are thermally-conductive blades and the step of reciprocating comprises imparting a displacement of the cooling fins.

In one embodiment, the cooling fins are flexible and the step of reciprocating comprises imparting a displacement of the cooling fins towards a proximal end of each cooling fin to generate a greater displacement of the cooling fins towards a distal end.

In one embodiment, the step of reciprocating comprises providing a Piezo-electric assembly which receives each cooling fin and reciprocating the cooling fins using the Piezo-electric assembly in response to a driving signal.

In one embodiment, the Piezo-electric assembly comprises grapheme.

In one embodiment, the heat sink base comprises a plurality of base modules, each base module arranged to receive a cooling fin and associated displacement mechanism operable to reciprocate that cooling fin.

In one embodiment, the method comprises the step of switching between an activated state where the cooling fins are reciprocated and an inactive state where the cooling fins remain static.

In one embodiment, the method comprises the step of remaining in the inactive state until a temperature of the heat-generating component exceeds a threshold value where the displacement mechanism switches to the activated state.

In one embodiment, the step of reciprocating comprises varying at least one of a frequency and amplitude of reciprocation of the cooling fins in response to a temperature of the heat-generating component.

In one embodiment, the step of reciprocating comprises reciprocating the cooling fins at their resonant frequency.

In one embodiment, the step of reciprocating comprises reciprocating the cooling fins at an ultrasonic frequency.

In one embodiment, the cooling fins are arranged in a plurality of rows.

In one embodiment, the step of reciprocating comprises reciprocating adjacent rows out of phase with respect to each other.

In one embodiment, the cooling fins upstand from the heat sink base.

In one embodiment, the cooling fins upstand at a non-normal inclination from the heat sink base.

In one embodiment, the cooling fins are metallic blades.

In one embodiment, the cooling fins comprise surface undulations.

In one embodiment, the method comprises the step of oppositely charging adjacent cooling fins to provide a flow of ionised particles.

In one embodiment, the step of reciprocating generates a fluid flow directable onto an adjacent heat-generating component to be cooled..

Further particular and preferred aspects are set out in the accompanying independent and dependent claims. Features of the dependent claims may be combined with features of the independent claims as appropriate, and in combinations other than those explicitly set out in the claims.

Where an apparatus feature is described as being operable to provide a function, it will be appreciated that this includes an apparatus feature which provides that function or which is adapted or configured to provide that function.

### BRIEF DESCRIPTION OF THE DRAWINGS

Embodiments of the present invention will now be described further, with reference to the accompanying drawings, in which:
Figure 1 illustrates a component of a cooling assembly according to one embodiment;
Figure 2 illustrates the interaction between the cooling assembly shown in Figure 1 and the ambient environment;
Figure 3 shows a schematic representation of a cooling assembly for cooling a heat generating component according to one embodiment;
Figure 4 shows a schematic representation of a cooling assembly for cooling a heat generating component with reciprocating cooling fins according to one embodiment;
Figure 5A shows a schematic representation of odd rows of a cooling assembly for cooling a heat generating component with reciprocating cooling fins according to one embodiment;
Figure 5B shows a schematic representation of even rows of a cooling assembly for cooling a heat generating component with reciprocating cooling fins according to one embodiment;
Figure 6 shows a schematic representation of a cooling assembly for cooling a heat generating component with inclined reciprocating cooling fins according to one embodiment; and
Figures 7A and 7B shows part of a schematic representation of a cooling assembly for cooling a heat generating component with reciprocating ionising cooling fins according to one embodiment.

### DESCRIPTION OF THE EMBODIMENTS

### Overview

Before discussing the embodiments in any more detail, first an overview will be provided. Unlike in previous passive cooling assembly or heat sink arrangements which rely simply on providing sufficient area to enable passive convection to occur or previous active assemblies which rely on forced air cooling provided by a fan, both of which increase the volume envelope of the heat sink or cooling assembly, embodiments provide an approach where the cooling fins themselves undergo displacement to improve the heat transfer between the cooling assembly and the ambient surrounding environment. This is achieved by agitating or displacing the cooling fins to encourage the breakup of thermal and flow boundary layers of the ambient air or fluid surrounding the cooling assembly which also promotes more flow mixing and heat transfer from the surface of the cooling fins to the surrounding ambient environment and provides for more effective cooling by increasing heat transfer to the ambient.

This approach takes the structure of a passive heat sink concept and converts it into an active heat sink which provides associated cooling advantages. In particular, this approach significantly augments a heat sink's heat transfer capability to ambient compared to that achieved by an equivalent passive heat sink which is cooled simply by natural convection. Unlike other forced cooling approaches, this approach achieves active cooling using a smaller volume which occupies less real-state than equivalent existing active solutions. In addition, the cooling fins may be reciprocated in the ultrasonic frequency range in order to generate less audible noise than other forced cooling arrangements.

### Cooling Assembly Module

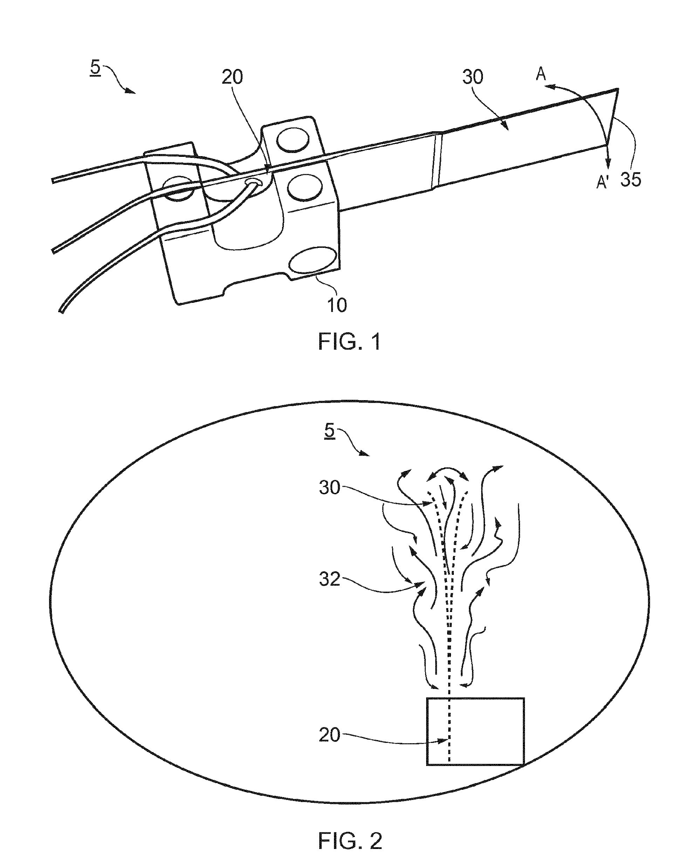

Figure 1 illustrates a component of a cooling assembly according to one embodiment. A heat sink base 10 is provided which is made of a high thermal conductivity material. Received within the heat sink base 10 is a Piezo-electric shim 20. The Piezo-electric shim 20 is electrically coupled with a signal generator (not shown) which supplies drive signals to either side of the Piezo-electric shim 20 to cause displacement. Supplying an oscillating signal to the Piezo-electric shim 20 causes the Piezo-electric shim 20 to reciprocate between the direction A-A'. Received within the Piezo-electric shim 20 is a cooling fin 30. Again, the cooling fin 30 is made of a high-thermal conductivity material. As will be appreciated, displacement of the Piezo-electric shim 20 between the direction A-A' causes a corresponding deflection of the cooling fin 30. Also, it is desirable for the cooling fin 30 to be flexible which causes additional displacement towards the distal end 35 of the cooling fin 30. In embodiments, both the Piezo-electric shim 20 and the cooling fin 30 is made of a Piezo-electric material. It will be appreciated that the arrangement shown in Figure 1 is an experimental configuration and that the configuration and dimensions of a cooling assembly utilising reciprocating cooling fins may be optimized to suit any particular application.

Figure 2 illustrates the interaction between the cooling assembly 5 shown in Figure 1 and the ambient environment. As can be seen, the reciprocation of the cooling fin 30 increases heat transfer to ambient by causing breakup of thermal and flow boundary layers 32 in addition to promoting more flow mixing and heat transfer from the cooling fin 30 to the surrounding ambient fluid.

### Single Row Cooling Assembly

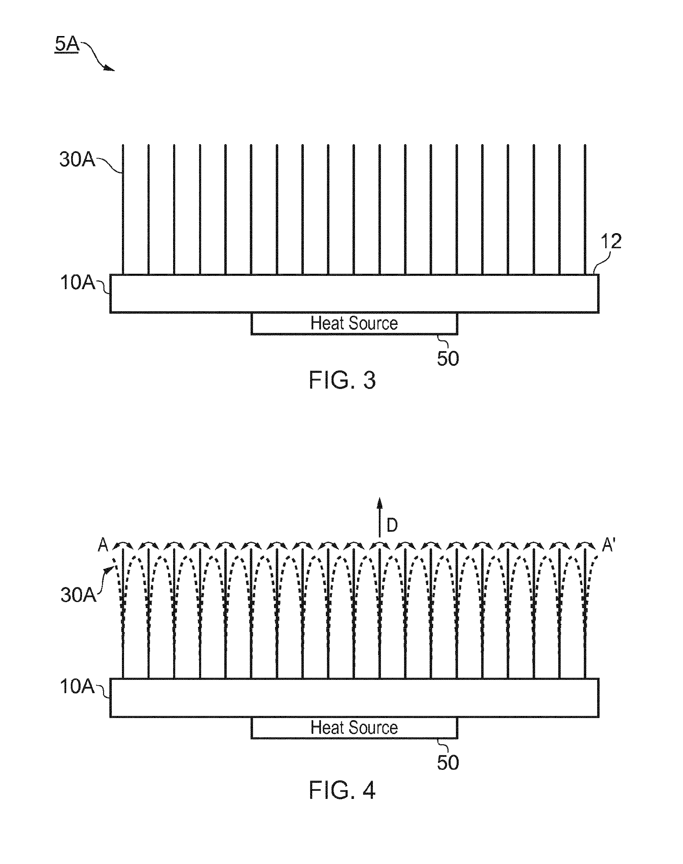

Figure 3 shows a schematic representation of a cooling assembly for cooling a heat generating component according to one embodiment. As can be seen, the cooling assembly, generally 5A, is thermally coupled with a heat generating component 50. In this arrangement, a heat sink base 10A is provided which couples with the heat generating component 50, typically by way of a thermal paste (not shown) at the interface between the heat generating component 50 and the heat sink base 10A. This provides a thermal path from the heat generating component 50 to the heat sink base 10A.

Embedded within and thermally coupled with the heat sink base 10A is a plurality of cooling fins 30A. In this example, the cooling fins 30A upstand in a direction normal to the major face 12 of the heat sink base 10A in which they are received. Each of the cooling fins 30A may be reciprocated in response to a drive signal provided by a driver (not shown).

Figure 3 shows the arrangement of the cooling assembly 5A in a passive or inactive state, where no signal is provided by the driver and the cooling fins 30A are static. In this state, the cooling assembly 5A operates as a conventional passive heat sink. The driver remains in the passive state until the temperature of the heat generating component 50 exceeds a threshold amount.

When the temperature of the heat generating component 50 exceeds the threshold amount then the driver provides signals which cause the cooling fins 30A to reciprocate, as can be seen in Figure 4. This reciprocation causes a disruption in the boundary layer around the cooling fins 30A shown in Figure 2, thereby increasing the heat transfer to ambient. In this example, the signal supplied by the driver causes each of the cooling fins 30A to reciprocate in phase with an adjacent cooling fin. That is to say, all of the cooling fins 30A deflect in the direction A at the same time and deflect in the direction A' at the same time. This enables the cooling fins to be placed closer together than would be possible if they reciprocated out of phase, since otherwise they would impact on each other. Also, because the cooling fins 30A can be reciprocated, the distance between adjacent fins can be reduced compared to that which would be possible in a passive arrangement which only relied on natural convection of ambient fluid for the dissipation of heat. By decreasing the distance between adjacent cooling fins 30A, an increased surface area of cooling fins per unit volume can be achieved. This enables a more compact arrangement of cooling assembly to be provided. In addition, by reciprocating the cooling fins 30A, the need for any additional forced air provider (such as a fan) is obviated, which again reduces the unit volume of the cooling assembly 5A. Furthermore, the reciprocation of the cooling fins 30A causes a fluid flow generally in the direction D which can be used to help cool adjacent components. Again, such an arrangement is not possible with existing passive heat sinks or forced air heat sinks which drive air in a direction opposite to the direction D.

As the temperature of the heat generating component 50 increases, the amplitude and/or the frequency of the signal used to control the reciprocation of the cooling fins 30A is increased. This helps to match the cooling effect of the reciprocating cooling fins 30A to the heat dissipation needs of the heat generating device 50. Typically, the frequency of the signal provided to drive the reciprocation of the cooling fins 30A will be increased until a resonant frequency of the cooling fins 30A is achieved. It will be appreciated that at a resonant frequency, a maximum displacement of the cooling fins 30A is achieved for a given amplitude signal. In other words, the efficiency of the driving signal is at its maximum at the resonant frequency. Also, increasing the amplitude of the drive signal increases the displacement of the cooling fins 30A to increase their cooling efficiency.

### Multiple Row Cooling Assembly

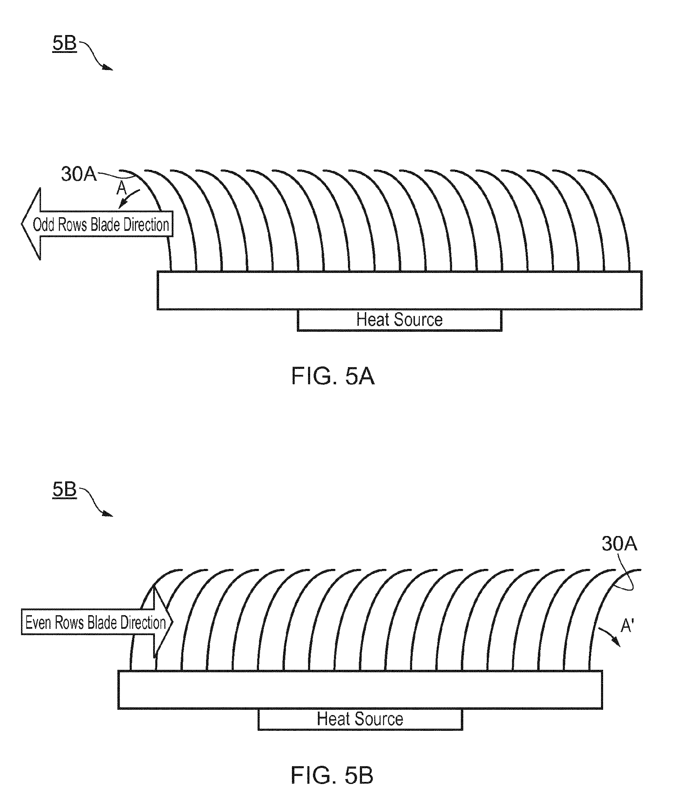

Figures 5A and 5B show a schematic representation of a cooling assembly for cooling a heat generating component according to one embodiment. Figure 5A shows a section through an 'odd' row, whilst Figure 5B shows a section through an `even' row. This arrangement is similar to that shown in Figure 4, but rather than having just one row of cooling fins 30A, multiple rows of cooling fins 30A are provided. Such an arrangement provides a cooling assembly comprising an array of N by M cooling fins 30A, where N is the number of cooling fins 30A in each row and M is the number of rows of cooling fins in the cooling assembly 5B.

In this arrangement, the controller drives adjacent rows of cooling fins 30A to reciprocate out of phase with respect to each other. As can be seen in Figures 5A and 5B, when the odd rows of cooling fins 30A are deflected in the direction A, the even rows of cooling fins 30A are deflected in the direction A'. This counter-reciprocation helps to increase turbulent airflow and improve heat dissipation to ambient.

### Reduced Height Cooling Assembly

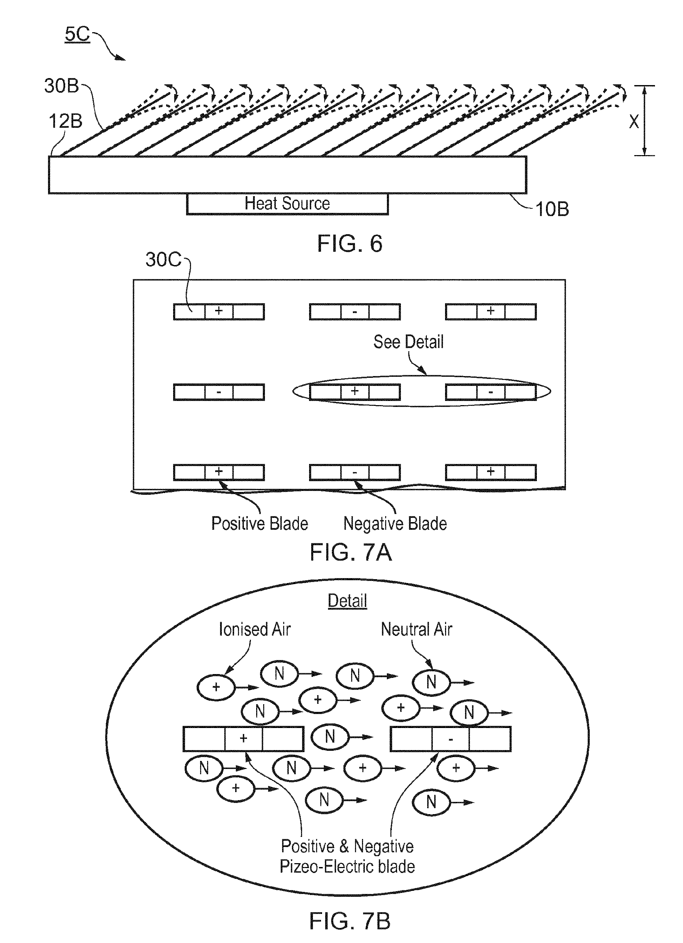

Figure 6 shows a schematic representation of a cooling assembly for cooling a heat generating component according to one embodiment. In this arrangement, the cooling assembly, generally 5C, is similar to the arrangement shown in Figure 4 but the cooling fins 30B are instead inclined away from an angle which is normal to the major surface 12B of the heat sink base 10B within which they are received. This provides for a cooling assembly having a reduced height X compared to that of the arrangement shown in Figures 4 and 5. As with Figure 4, the cooling fins 30B are driven in phase by the driver to reciprocate as shown.

In a similar manner to that illustrated in Figure 5, adjacent rows of heat sink blades 30B may be provided, each of which may be reciprocate in opposite phase to each other. Likewise, the adjacent rows may have opposite inclination angles so that the adjacent rows are inclined in opposing directions.

### Ionic Cooling Assembly

Figures 7A and 7B shows an arrangement which increases heat dissipation through the generation of a flow of ions between cooling fins. In particular, adjacent fins 30C (either within rows and/or between rows) are oppositely charged which generates ionised particles which travel between these cooling fins and assist the flow of air between fins.

It will be appreciated that in each embodiment rather than having a Piezo-electric section which displaces the cooling fin, the entire cooling fin could be of a Piezo-electric material such that the entire cooling fin displaces under the action of the drive signal. Likewise, it will be appreciated that other displacement mechanisms may be utilised other than by using Piezo-electric materials. For example, mechanical actuators (such as motors or solenoids or sonic or ultrasonic devices or other electro-mechanical materials) may be utilised in order to effect the reciprocation of the cooling fins.

It will also be appreciated that Piezo-electric blades are solid state devices that are caused to oscillate by being driven by an oscillating low voltage drive signal, typically equal to the resonant frequency of the blades. The drive circuit which delivers the low voltage and periodic signal to oscillate the blades can be either incorporated into the printed circuit board (PCB) design of the PCB which houses the components to be cooled, or mounted as a daughterboard to dry several cooling or heat sink assemblies. It will be appreciated that embodiments provide for many advantages. For example, the cooling or heat sink assembly can be controlled to oscillate periodically between the active and passive states to control the temperature of the devices mounted below them. The heat sink assembly can be controlled to remain in a passive state until cooling is required, whereupon they become active. The heat sink can be designed so that each row of blades is out of phase with the preceding row, thus creating even more turbulent flow, mixing and cooling for devices. The heat sinks can be designed to work at specific amplitudes and frequency dependent on the PCB design, so that optimal cooling can be achieved for each design. Where several boards are mounted side by side, the heat sink assembly can be used to cool both the device and any adjacent devices or PCBs. To reduce weight and increase the thermal conductivity through the Piezo-electric blades, the blades can also be made from grapheme using known techniques developed by Stanford researchers. The blades can be mounted at various different inclines from the base plate face. That configuration can be used where there are height restrictions or where it is desired to encourage the flow of cooling fluid in a certain direction. The active heat sink can further be enhanced with the inclusion of electro-hydrodynamics to create ionic winds. The ionic winds can be generated by having two differently charged blades, where ionised air is created at the positively charged blade which then flows to the negatively charged blade with increased mass flow rates generated through mass transfer interaction between the ionised air current and the non-ionised air. The cooling blade surfaces can also include features that increase the surface area whilst limiting drag and pressure losses, such as, for example, providing a dimple or recess arrangement similar to that found on golf balls.

A person of skill in the art would readily recognize that steps of various above-described methods can be performed by programmed computers. Herein, some embodiments are also intended to cover program storage devices, e.g., digital data storage media, which are machine or computer readable and encode machine-executable or computer-executable programs of instructions, wherein said instructions perform some or all of the steps of said above-described methods. The program storage devices may be, e.g., digital memories, magnetic storage media such as a magnetic disks and magnetic tapes, hard drives, or optically readable digital data storage media. The embodiments are also intended to cover computers programmed to perform said steps of the above-described methods.

The functions of the various elements shown in the Figures, including any functional blocks labelled as "processors" or "logic", may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term "processor" or "controller" or "logic" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. A cooling assembly, comprising:
a heat sink base thermally coupleable with a heat-generating component to be cooled;
cooling fins thermally connected with said heat sink base to provide a thermal path from said heat-generating component to said cooling fins; and
a displacement mechanism operable to reciprocate said cooling fins.

2. The cooling assembly of claim 1, wherein said cooling fins are thermally-conductive blades and said displacement mechanism imparts a displacement of said cooling fins.

3. The cooling assembly of claim 1 or 2, wherein said cooling fins are flexible and said displacement mechanism imparts a displacement of the cooling fins towards a proximal end of each cooling fin to generate a greater displacement of the cooling fins towards a distal end.

4. The cooling assembly of any preceding claim, wherein said displacement mechanism comprises a Piezo-electric assembly which receives each cooling fin, said Piezo-electric assembly being operable to reciprocate said cooling fins in response to a driving signal.

5. The cooling assembly of any preceding claim, wherein said displacement mechanism and cooling fin both comprise said Piezo-electric assembly.

6. The cooling assembly of claim 5, wherein said Piezo-electric assembly comprises grapheme.

7. The cooling assembly of any preceding claim, wherein said displacement mechanism is operable to switch between an activated state where said cooling fins are reciprocated and an inactive state where said cooling fins remain static and said displacement mechanism is operable to remain in said inactive state until a temperature of said heat-generating component exceeds a threshold value where said displacement mechanism switches to said activated state.

8. The cooling assembly of any preceding claim, wherein said displacement mechanism is operable to vary at least one of a frequency and amplitude of reciprocation of said cooling fins in response to a temperature of said heat-generating component.

9. The cooling assembly of any preceding claim, wherein said displacement mechanism is operable to reciprocate said cooling fins at their resonant frequency.

10. The cooling assembly of any preceding claim, wherein said displacement mechanism is operable to reciprocate said cooling fins at an ultrasonic frequency.

11. The cooling assembly of any preceding claim, wherein said cooling fins are arranged in a plurality of rows and said displacement mechanism is operable to reciprocate adjacent rows out of phase with respect to each other.

12. The cooling assembly of any preceding claim, wherein said cooling fins comprise surface undulations.

13. The cooling assembly of any preceding claim, comprising a voltage generator operable to oppositely charge adjacent cooling fins to provide a flow of ionised particles.

14. The cooling assembly of any preceding claim, wherein said reciprocation of said cooling fins generates a fluid flow directable onto an adjacent heat-generating component to be cooled.

15. A cooling method, comprising:
providing a heat sink base thermally coupleable with a heat-generating component to be cooled;
thermally connecting cooling fins with said heat sink base to provide a thermal path from said heat-generating component to said cooling fins; and
reciprocating said cooling fins.
